# EUROPEAN PATENT APPLICATION

(11) **EP 4 520 599 A1**
(43) Date of publication of application: **12.03.2025**
(21) Application number: 23903708.8
(22) Date of filing: 16.10.2023
(51) Int. Cl.: B60R 16/033, H02J 1/06, H02M 3/158, H03M 1/12, B60R 16/023

(54) **BATTERY SYSTEM AND POWER TRANSMISSION METHOD USING SAME**

(30) Priority: 16.12.2022 KR 20220177519
(71) Applicant: LG Energy Solution, Ltd., Seoul 07335 (KR)
(72) Inventor: SHIN, Seong Kyun, Daejeon 34122 (KR)
(74) Representative: Plasseraud IP
(86) International application number: PCT/KR2023/015952
(87) International publication number: WO 2024/128504

(57) **Abstract**

Provided are a battery system and a power delivery method using the same, the battery system including: a battery pack; and a battery management system (BMS) receiving an auxiliary voltage from an auxiliary (AUX) line, selecting one of a first power path and a second power path from the auxiliary voltage to a plurality of driving elements based on a level of the auxiliary voltage, and supplying power to the plurality of driving elements through the selected one power path, wherein the BMS includes a first wiring configuring the first power path, a second wiring configuring the second power path, a switching element including a first end to which the auxiliary voltage is provided, a second end which is connected to the first wiring, and a third end which is connected to the second wiring, and a buck-boost element stepping down the voltage supplied through the second wiring.

## Description

### [Technical Field]

### Cross-Citation with Related Application(s)

This application claims the benefit of priority based on Korean Patent Application No. 10-2022-0177519 filed in the Korean Intellectual Property Office on December 16, 2022, and all contents disclosed in the document of the Korean patent application are incorporated as a part of this specification.

The present disclosure relates to a battery system and a power delivery method using the same.

### [Background Art]

A voltage supplied from an auxiliary (AUX) terminal of a vehicle may be 12 V or 24 V. A conventional battery system may be classified into a system corresponding to 12V and a system corresponding to 24V.

A separate element may be provided in a path based on each voltage level in order to perform the classification into the systems corresponding to each voltage level as described above. Accordingly, a battery management system (BMS) including the element for each voltage level may have a large number of elements, which may cause an insufficient space on a board or require a board for each voltage level.

### [Summary]

### [Technical Problem]

The present disclosure attempts to provide a battery system for determining a power path through which a voltage is delivered to various elements based on a level of the voltage input from an auxiliary (AUX) terminal, and a power delivery method using the same.

### [Technical Solution]

According to an embodiment, provided is a battery system including:
a battery pack; and a battery management system (BMS) receiving an auxiliary voltage from an auxiliary (AUX) line, selecting one of a first power path and a second power path from the auxiliary voltage to a plurality of driving elements based on a level of the auxiliary voltage, and supplying power to the plurality of driving elements through the selected one power path, wherein the BMS includes a first wiring configuring the first power path, a second wiring configuring the second power path a switching element including a first end to which the auxiliary voltage is provided, a second end which is connected to the first wiring, and a third end which is connected to the second wiring, and a buck-boost element stepping down the voltage supplied through the second wiring.

The BMS further may include a main control unit (MCU) generating a switch control signal based on a signal indicating a noise-filtered voltage from the auxiliary voltage, and the switching element may connect the first end to the second end or the third end based on the switch control signal.

The BMS may further include an analog-digital converter (ADC) analog-digital converting the filtered voltage to generate a voltage signal indicating a level of the filtered voltage, and transmitting the generated signal to the MCU.

Each of the plurality of driving elements is driven at a voltage level of a first voltage, the MCU may generate the switch control signal of a first level when the noise-filtered voltage has a level corresponding to the first voltage, and the switching element connectsthe second end to the first end.

The MCU may generate the switch control signal of a second level when the noise-filtered voltage has a level corresponding to a second voltage, the switching element connects the third end to the first end, and the buck-boost element may output the voltage of the level corresponding to the first voltage by stepping down the voltage supplied through the second wiring, and supply the outputed voltage to the plurality of driving elements.

According to another embodiment, provided is a power delivery method including: receiving, by a battery management system (BMS), an auxiliary voltage from an auxiliary (AUX) line of a vehicle; selecting, by the BMS, one of a first power path and a second power path from the auxiliary voltage to a plurality of driving elements driven at a voltage level of a first voltage based on a level of the auxiliary voltage; connecting, by the BMS, a first end to a second end or a third end based on the selection by using a switching element including the first end to which the auxiliary voltage is provided, the second end which is connected to a first wiring configuring the first power path, and the third end which is connected to a second wiring configuring the second power path; and supplying power to the plurality of driving elements through the selected one power path.

The selecting of the one of the first power path and the second power path may include analog-to-digital converting a noise-filtered voltage from the auxiliary voltage to generate a voltage signal indicating a level of the noise-filtered voltage; and generating a switch control signal based on the voltage signal.

The method, in which the switch control signal has a first level when the noise-filtered voltage has a level corresponding to the first voltage, may further include connecting, by the switching element, the second end to the first end based on the switch control signal.

The method, in which the switch control signal has a second level when the noise-filtered voltage has a level corresponding to a second voltage, may further include connecting, by the switching element, the third end to the first end based on the switch control signa.

The method may further include: outputting, by the buck-boost element, the voltage of the level corresponding to the first voltage by stepping down the voltage supplied through the second wiring; and supplying, by the buck-boost element, the outputed voltage to the plurality of driving elements.

### [Advantageous Effects]

According to the present disclosure, the 12 V and 24 V systems may be implemented as one battery management system (BMS) mounted on one board, and the 12V system and the 24V system may thus be flexibly utilized only by managing a bill of materials (BOM).

According to the present disclosure, both of the 12 V and 24 V systems may be designed using one board, and the BMS may thus be designed regardless of the 12 V or 24 V AUX system provided by the vehicle terminal.

### [Brief Description of the Drawings]

FIG. 1 is a block diagram schematically showing a battery system according to an embodiment.
FIG. 2 shows a power path when a first auxiliary voltage is supplied from an auxiliary (AUX) line.
FIG. 3 shows the power path when a second auxiliary voltage is supplied from the auxiliary (AUX) line.
FIG. 4 is a flowchart of a power delivery method using a battery system according to another embodiment.

### [Detailed Description]

Hereinafter, embodiments disclosed in the specification are described in detail with reference to the accompanying drawings, the same or similar components are denoted by the same or similar reference numerals, and an overlapping description thereof is omitted. Terms "module" and/or "unit" for components described in the following description are used only to make the specification easily understood. Therefore, these terms do not have meanings or roles distinguished from each other in themselves. Further, in describing the embodiments of the present disclosure, omitted is a detailed description when it is decided that the detailed description of the known art related to the present disclosure may obscure the gist. Furthermore, it is to be understood that the accompanying drawings are provided only to allow the embodiment of the present disclosure to be easily understood, and the spirit of the present disclosure is not limited by the accompanying drawings and includes all the modifications, equivalents and substitutions included in the spirit and scope of the present disclosure.

Terms including ordinal numbers such as "first," "second" and the like, may be used to describe various components. However, these components are not limited by these terms. The terms are used only to distinguish one component from another component.

It is to be understood that terms "include," "have" and the like used in the present application specify the presence of features, numerals, steps, operations, components, parts or combinations thereof, mentioned in the specification, and do not preclude the presence or possible addition of one or more other features, numerals, steps, operations, components, parts or combinations thereof.

A program implemented as a set of instructions embodying a control algorithm necessary to control another configuration may be installed in a configuration for controlling another configuration under a specific control condition among configurations according to an embodiment. The control configuration may process input data and stored data, based on the installed program to thus generate output data. The control configuration may include a non-volatile memory that stores the program and a memory that stores the data.

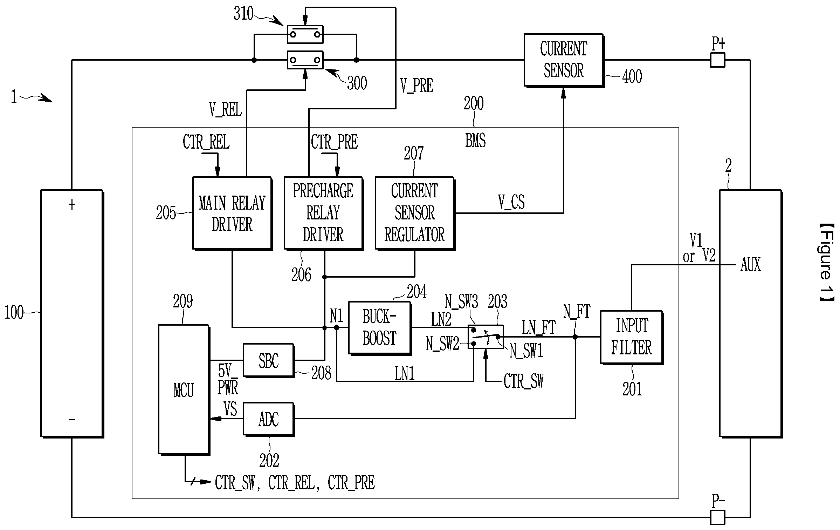

FIG. 1 is a block diagram schematically showing a battery system according to an embodiment.

Referring to FIG. 1, a battery system 1 may include a battery pack 100, a battery management system (BMS) 200, a main relay 300, a precharge relay 310, and a current sensor 400.

The battery pack 100 may be implemented as two or more battery cells connected in series with each other, a plurality of battery cells connected in series with each other in which two or more battery cells are connected in parallel with each other, or two or more battery cells connected in parallel with each other.

One end of the precharge relay 310 may be connected to one end of the main relay 300, and the other end of the precharge relay 310 may be connected to the other end of the main relay 300. One end of each of the main relay 300 and the precharge relay 310 may be connected to the battery pack 100, and the other end of each of the main relay 300 and the precharge relay 310 may be connected to at least one component of an external device 2.

The BMS 200 may include an input filter 201, an analog-digital converter (ADC) 202, a switching element 203, a buck-boost element 204, and a plurality of driving elements 205 to 208, and a main control unit (MCU) 209. The plurality of driving elements 205 to 208 are respective examples of elements operated to control charging and discharging of the battery pack 100.

The BMS 200 may receive an auxiliary voltage from an auxiliary (AUX) line, determine a power path for connecting the auxiliary voltage to the plurality of driving elements 205 to 208 based on a level of the auxiliary voltage, and supply power to the plurality of driving elements 205 to 208 through a wiring of the power path.

The BMS 200 may include at least one AUX line. For example, the auxiliary voltage of a vehicle may be supplied through the AUX line. Hereinafter, for convenience of explanation, the description describes that one of a first auxiliary voltage V1 and a second auxiliary voltage V2 is supplied through the AUX line. The second auxiliary voltage V2 may be higher than the first auxiliary voltage V1. For example, the first auxiliary voltage V1 may be 12 V and the second auxiliary voltage V2 may be 24 V.

The input filter 201 may filter the voltage supplied from the AUX line. One end of the input filter 201 may be connected to the AUX line, and the other end of the input filter 201 may be connected to one end of the switching element 203 through an output line LN_FT. The input filter 201 may be implemented as an inductor or a capacitor, and any of various known noise removal filters may be applied to the input filter 201. The voltage passed through the input filter 201 may be delivered to the switching element 203 through the output line LN_FT. The output line LN_FT may be a wiring that provides the power path from an output terminal of the input filter 201 to one end of the switching element 203.

One end of the ADC 202 may be connected to a node N_FT on the output line LN_FT, and the other end of the ADC 202 may be connected to the MCU 209. The ADC 202 may generate a voltage signal VS by analog-to-digital converting a signal indicating the voltage at the node N_FT. The voltage signal VS may be a signal indicating a level of the voltage output from the input filter 201.

The plurality of driving elements 205 to 208 may include at least one of a main relay driver 205, a precharge relay driver 206, a current sensor regulator 207, and a system basis chip (SBC) 208. A voltage level of power required for operating the plurality of driving elements 205 to 208 may be a voltage level of the first auxiliary voltage V1. FIG. 1 shows that the plurality of driving elements are the main relay driver 205, the precharge relay driver 206, the current sensor regulator 207, and the SBC 208. However, the present disclosure is not limited thereto. For example, the plurality of driving elements may include a high voltage interlock connector (HVIL).

The main relay driver 205 may control driving of the main relay 300. Opening and closing of the main relay 300 may be controlled by a main relay control signal CTR_REL supplied from the MCU 209. The main relay driver 205 may supply a main relay driving voltage V_REL to the main relay 300 which opens or closes the main relay 300 based the main relay control signal CTR_REL.

The precharge relay driver 206 may control driving of the precharge relay 310. The opening and closing of the precharge relay 310 may be controlled by a precharge relay control signal CTR_PRE supplied from the MCU 209. The precharge relay driver 206 may supply a precharge relay driving voltage V_PRE to the precharge relay 310 which opens or closes the precharge relay 310 based on the precharge relay control signal CTR_PRE.

The current sensor regulator 207 may supply a driving voltage V_CS to the current sensor 400 which measures a current flowing in a high voltage path to which the battery pack 100 is connected. The current sensor 400 may be disposed on a high voltage line connected from the battery pack 100 to both ends P+ and P- of the battery system 1. For example, when an excessive current flows in the high voltage path, a circuit phenomenon may occur in the pack, and the MCU 209 may detect this phenomenon by monitoring current information acquired by the current sensor 400. The current sensor 400 may be implemented as a resistance detection type sensor that detects the current by using a resistance or a magnetic field detection type sensor that detects a magnetic field.

The SBC 208 may supply power to the MCU 209. The SBC 208 may generate a driving voltage 5V_PWR of the MCU 209 and supply the same to the MCU 209.

The switching element 203 may include a first end N_SW1, a second end N_SW2, and a third end N_SW3.

The first end N_SW1 of the switching element 203 may be connected to the node N_FT through the output line LN_FT.

A first wiring LN1 may be a wiring that provides the power path from an output of the input filter 201 to a node N1 connected to one end of each of the plurality of driving elements 205 to 208. One end of the first wiring LN1 may be connected to the second end N_SW2 of the switching element 203, and the other end of the first wiring LN1 may be connected to the node N1.

A second wiring LN2 may be a wiring that provides the power path from the output of the input filter 201 to the buck-boost element 204. One end of the second wiring LN2 may be connected to the third end N_SW3 of the switching element 203, and the other end of the second wiring LN2 may be connected to one end of the buck-boost element 204.

The MCU 209 may generate a switch control signal CTR_SW based on the voltage signal VS received from the node N_FT through the ADC 202. The MCU 209 may select the power path from the first auxiliary voltage V1 or the second auxiliary voltage V2 to the plurality of driving elements 205 to 208 through the switch control signal CTR_SW. The MCU 209 may select one of a first power path configured by the first wiring LN1 and a second power path configured by the second wiring LN2. The MCU 209 may generate the switch control signal CTR_SW of a first level when the voltage signal VS has a level corresponding to the first auxiliary voltage V1. The MCU 209 may generate the switch control signal CTR_SW of a second level when the voltage signal VS has a level corresponding to the second auxiliary voltage V2.

When the switch control signal CTR_SW has the first level, the switching element 203 may connect the output line LN_FT of the input filter 201 to the first wiring LN1. When the switch control signal CTR_SW has the second level, the switching element 203 may connect the output line LN_FT of the input filter 201 to the second wiring LN2. The BMS 200 may supply power to the plurality of driving elements 205 to 208 through one power path selected from the first power path configured by the first wiring LN1 and the second power path configured by the second wiring LN2.

A configuration of the buck-boost element 204 and step-up and step-down methods of the buck-boost element 204 are not particularly limited. The buck-boost element 204 may be operated when the voltage corresponding to the second auxiliary voltage V2 is supplied thereto through the second wiring. The buck-boost element 204 may output the voltage of the level corresponding to the first auxiliary voltage by stepping down the voltage input through the second wiring LN2. The other end of the buck-boost element 204 may be connected to the wirings connected to the plurality of driving elements 205 to 208 through the node N1.

Power may be supplied to the plurality of driving elements 205 to 208 through the first wiring LN1 or the buck-boost element 204.

The main relay driver 205 may use a voltage of power supplied through the node N1 as its driving voltage. When the main relay control signal CTR_REL supplied from the MCU 209 is an on-level signal, the main relay driver may generate the main relay driving voltage V_REL by using the voltage of power supplied through the node N1, and close the main relay 300 by providing the main relay driving voltage V_REL to the main relay 300.

The precharge relay driver 206 may use power supplied through the node N1 as its driving voltage. When the precharge relay control signal CTR_PRE supplied from the MCU 209 is the on-level signal, the precharge relay driver may generate the precharge relay driving voltage V_PRE by using the voltage of power supplied through the node N1, and close the precharge relay 310 by providing the precharge relay driving voltage V_PRE to the precharge relay 310.

The current sensor regulator 207 may supply the driving voltage V_CS required for operating the current sensor 400 by converting the voltage of power supplied through the node N1 to a voltage of a level suitable for the current sensor 400.

The SBC 208 may generate the voltage of 5V_PWR based on power supplied through the node N1 and supply the same to the MCU 209.

FIG. 1 shows one node N1. However, the present disclosure is not limited thereto. The BMS 200 may include two or more nodes connected to the first wiring LN1 and the other end of the buck-boost element 204, and the plurality of driving elements 205 to 208 may be connected to the first wiring or the other end of buck-boost element 204 through two or more nodes.

The battery system 1 may be connected to the external device 2. The external device 2 may include a loading or charging device such as an inverter or a converter. When the external device 2 is a charger, both the ends P+ and P- of the battery system 1 may be connected to the charger and supplied with power from the charger to be charged. When the external device 2 is a load, both the ends P+ and P- of the battery system 1 may be connected to the load, and power supplied by the battery pack 100 may thus be discharged through the load.

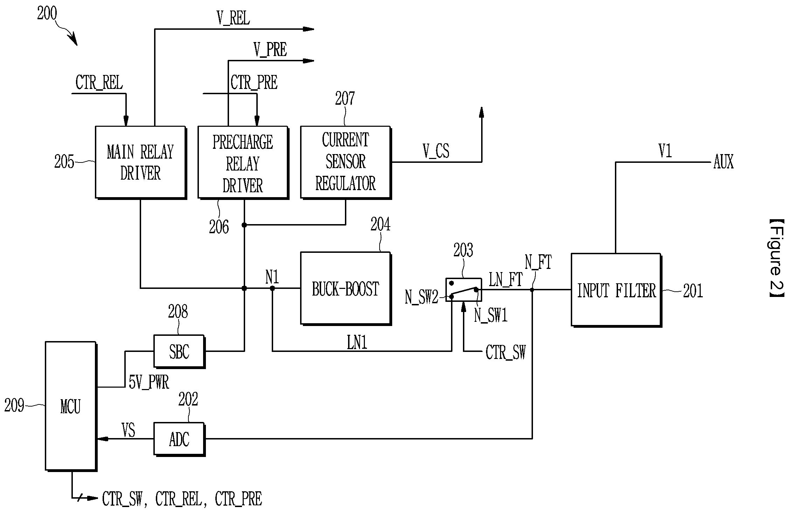

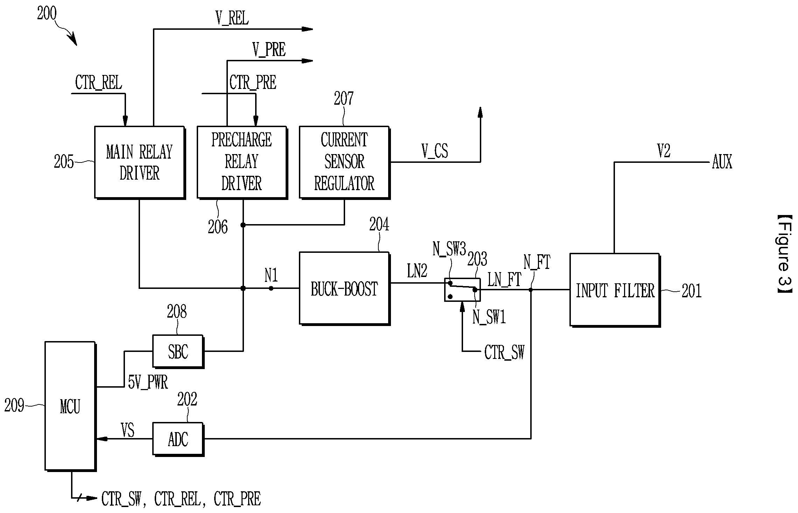

Hereinafter, the description describes the power path of the voltage supplied from the AUX line with reference to FIGS. 2 and 3.

FIG. 2 shows the power path when the first auxiliary voltage is supplied from an auxiliary (AUX) line.

Referring to FIG. 2, when the first auxiliary voltage V1 is supplied to the AUX line, the input filter 201 may deliver a noise-filtered voltage from the first auxiliary voltage V1 to the switching element 203 through the output line LN_FT. The ADC 202 may transmit, to the MCU 209, the voltage signal VS which is a digital conversion of the voltage at the node N_FT on the output line LN_FT.

The voltage signal VS may have the level corresponding to the first auxiliary voltage V1, and the MCU 209 may thus generate the switch control signal CTR_SW of the first level and transmit the same to the switching element 203.

The switching element 203 receiving the switch control signal CTR_SW of the first level may connect the first end N_SW1 with the second end N_SW2 to thus connect the output line LN_FT of the input filter 201 to the first wiring LN1. The first wiring LN1 may be connected to the wirings connected to the plurality of driving elements 205 to 208 through the node N1.

Therefore, the first auxiliary voltage V1 supplied to the AUX line may be supplied to the plurality of driving elements 205 to 208 through the output line LN_FT of the input filter 201, the first wiring LN1, and the node N1.

FIG. 3 shows the power path when the second auxiliary voltage is supplied from the AUX line.

Referring to FIG. 3, when the second auxiliary voltage V2 is supplied to the AUX line, the input filter 201 may deliver the noise-filtered voltage from the second auxiliary voltage V2 to the switching element 203 through the output line LN_FT. The ADC 202 may transmit, to the MCU 209, the voltage signal VS which is the digital conversion of the voltage at the node N_FT on the output line LN_FT.

The voltage signal VS may have the level corresponding to the second auxiliary voltage V2, and the MCU 209 may thus generate the switch control signal CTR_SW of the second level and transmit the same to the switching element 203.

The switching element 203 receiving the switch control signal CTR_SW of the second level may connect the first end N_SW1 with the third end N_SW3 to thus connect the output line LN_FT of the input filter 201 to the second wiring LN2. The second wiring LN2 may be connected to the buck-boost element 204.

The buck-boost element 204 may be operated by the voltage input through the second wiring LN2, and may step up or down the input voltage to output the voltage of the level corresponding to the first auxiliary voltage. An output terminal of the buck-boost element 204 may be connected to the wirings connected to the plurality of driving elements 205 to 208 through the node N1. For example, when the first auxiliary voltage V1 is 12 V and the second auxiliary voltage V2 is 24 V, the buck-boost element 204 may step down the input voltage corresponding to 24 V and output the voltage of 12 V.

Therefore, the second auxiliary voltage V2 supplied to the AUX line may be supplied to the plurality of driving elements 205 to 208 through the output line LN_FT of the input filter 201, the second wiring LN2, the buck-boost element 204, and the node N1.

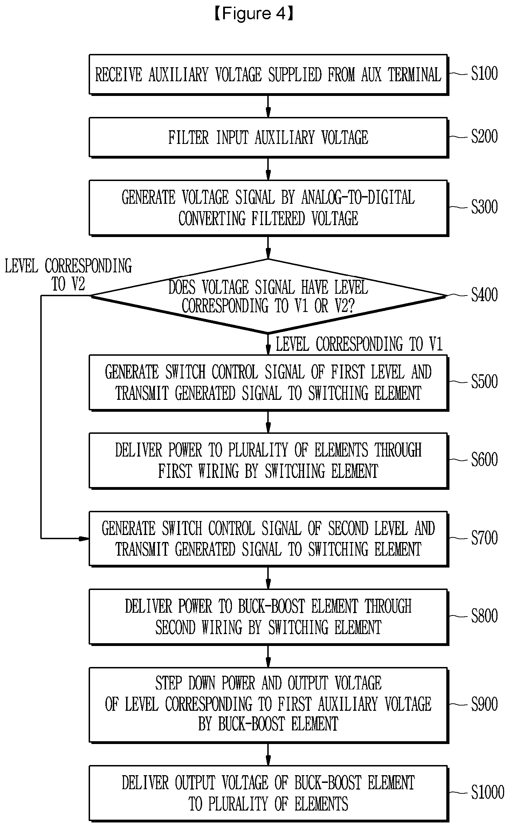

FIG. 4 is a flowchart of a power delivery method using a battery system according to another embodiment.

Hereinafter, the description may omit a description of a component that overlaps with the description thereof provided above among descriptions of respective components of a battery management system (BMS) 200.

Referring to FIG. 4, the BMS 200 may receive an auxiliary voltage supplied from an auxiliary (AUX) line (S100).

An input filter 201 may filter the input auxiliary voltage (S200).

An analog-digital converter (ADC) 202 may generate a voltage signal VS by analog-to-digital converting a signal indicating a voltage at a node N_FT on an output line LN_FT of the input filter 201 (S300).

A main control unit (MCU) 209 may select a path from a first auxiliary voltage V1 or a second auxiliary voltage V2 to a plurality of driving elements 205 to 208 as one of a first power path and a second power path through a switch control signal CTR_SW, and supply power to the plurality of driving elements 205 to 208 through the selected one power path.

The MCU 209 may receive the voltage signal VS from the ADC 202 to determine whether the voltage signal VS has a level corresponding to the first auxiliary voltage V1 or that of the second auxiliary voltage V2 (S400).

The MCU 209 may generate the switch control signal of a first level and transmit the same to a switching element 203 (S500) when the voltage signal VS has the level corresponding to the first auxiliary voltage V1 in step S400.

The switching element 203 receiving the switch control signal of the first level may connect a first end N_SW1 with a second end N_SW2, and deliver power to the plurality of driving elements 205 to 208 through a first wiring LN1 (S600).

The MCU 209 may generate the switch control signal of a second level and transmit the same to the switching element 203 (S700) when the voltage signal VS has a level corresponding to the second auxiliary voltage V2 in step S400.

The switching element 203 receiving the switch control signal of the second level may connect the first end N_SW1 with a third end N_SW3, and deliver power to a buck-boost element 204 through a second wiring LN2 (S800).

The buck-boost element 204 may step down power and output a voltage of the level corresponding to the first auxiliary voltage (S900).

The output voltage of the buck-boost element 204 may be delivered to the plurality of driving elements 205 to 208 (S1000). The plurality of driving elements 205 to 208 may be driven using the output voltage of the buck-boost element 204 as the driving voltage.

In this way, the switching element 203 may supply power to the plurality of driving elements 205 to 208 through a wiring of the power path determined by the MCU 209 among the first wiring LN1 and the second wiring LN2, based on the switch control signal received from the MCU 209.

Although the embodiments of the present disclosure have been described in detail hereinabove, the scope of the present disclosure is not limited thereto. Various modifications and improvements made by those skilled in the art to which the present disclosure pertains also belong to the scope of the present disclosure.

## Claims

1. A battery system comprising:
a battery pack; and
a battery management system (BMS) receiving an auxiliary voltage from an auxiliary (AUX) line, selecting one of a first power path and a second power path from the auxiliary voltage to a plurality of driving elements based on a level of the auxiliary voltage, and supplying power to the plurality of driving elements through the selected one power path, wherein the BMS includes
a first wiring configuring the first power path,
a second wiring configuring the second power path,
a switching element including a first end to which the auxiliary voltage is provided, a second end which is connected to the first wiring, and a third end which is connected to the second wiring, and
a buck-boost element stepping down the voltage supplied through the second wiring.

2. The system of claim 1, wherein
the BMS further includes
a main control unit (MCU) generating a switch control signal based on a signal indicating a noise-filtered voltage from the auxiliary voltage, and
the switching element connects
the first end to the second end or the third end based on the switch control signal.

3. The system of claim 2, wherein
the BMS further includes
an analog-digital converter (ADC) analog-digital converting the filtered voltage to generate a voltage signal indicating a level of the filtered voltage, and transmitting the generated signal to the MCU.

4. The system of claim 2, wherein
each of the plurality of driving elements is driven at a voltage level of a first voltage,
the MCU generates the switch control signal of a first level when the noise-filtered voltage has a level corresponding to the first voltage, and
the switching element connectsthe second end to the first end.

5. The system of claim 4, wherein
the MCU generates the switch control signal of a second level when the noise-filtered voltage has a level corresponding to a second voltage,
the switching element connects the third end to the first end, and
the buck-boost element outputs the voltage of the level corresponding to the first voltage by stepping down the voltage supplied through the second wiring, and supplies the outputed voltage to the plurality of driving elements.

6. A power delivery method comprising:
receiving, by a battery management system (BMS), an auxiliary voltage from an auxiliary (AUX) line of a vehicle;
selecting, by the BMS, one of a first power path and a second power path from the auxiliary voltage to a plurality of driving elements driven at a voltage level of a first voltage based on a level of the auxiliary voltage;
connecting, by the BMS, a first end to a second end or a third end based on the selection by using a switching element including the first end to which the auxiliary voltage is provided, the second end which is connected to a first wiring configuring the first power path, and the third end which is connected to a second wiring configuring the second power path; and
supplying power to the plurality of driving elements through the selected one power path.

7. The method of claim 6, wherein
the selecting of the one of the first power path and the second power path includes
analog-to-digital converting a noise-filtered voltage from the auxiliary voltage to generate a voltage signal indicating a level of the filtered voltage; and
generating a switch control signal based on the voltage signal.

8. The method of claim 7, in which
the switch control signal has a first level when the noise-filtered voltage has a level corresponding to the first voltage,
further comprising connecting, by the switching element, the second end to the first end based on the switch control signal.

9. The method of claim 7, in which
the switch control signal has a second level when the noise-filtered voltage has a level corresponding to a second voltage,
further comprising connecting, by the switching element, the third end to the first end based on the switch control signa.

10. The method of claim 9, further comprising:
outputting, by the buck-boost element, the voltage of the level corresponding to the first voltage by stepping down the voltage supplied through the second wiring; and
supplying, by the buck-boost element, the outputed voltage to the plurality of driving elements.
